# EUROPEAN PATENT APPLICATION

(11) **EP 1 641 043 A1**
(43) Date of publication of application: **29.03.2006**
(21) Application number: 04022647.4
(22) Date of filing: 23.09.2004
(51) Int. Cl.: H01L 25/075, H01L 33/00

(54) **Full-color light-emitting diode (LED) formed by overlaying red, green and blue LED diode dies**

(71) Applicant: Arima Optoelectronics Corporation, Taoyuan County Taiwan (CN)
(72) Inventor: Wang, Pei-Jih, Dashi Taoyuan County (TW); Chang, Pan-Tzu, Dashi Taoyuan County (TW); Huang, Andy, Dashi Taoyuan County (TW)
(74) Representative: Casalonga, Axel

(57) **Abstract**

A full-color light-emitting diode (LED) having a red LED die (21), a blue LED die (22), and a green LED die (23). The red LED (21) die serves as a supporting material on which the blue LED die (22) and the green LED (23) die are separately mounted in such a manner that the red LED (21) die is not completely covered to reserve a red-light emitting surface. In this way, the red (21), blue (22), and green (23) LED die forms a double-layer full-color LED to facilitate the packaging operation, to ensure a more compact mixture of red, green, and blue lights and to achieve an exact wave-mixing effect for obtaining a full-color light.

## Description

The invention relates to a full-color light-emitting diode (LED), and more particularly, to an LED in which a red LED die serves as a supporting material for a green LED die and a blue LED die to ensure a more compact mixture of the red, green, and blue lights and to achieve an exact wave-mixing effect for obtaining a full-color light.

LED is an essential semiconductor product in the modem scientific development. The research on materials made of elements of the third and fifth groups of periodic system has made a great progress due to the appearance of red LED about four decades ago. Thereafter, the discovery of the green and yellow LEDs has motivated many industries to undergo research, development, and fabrication of related products. Recently, blue and green LEDs of high brightness have been developed by use of materials made of the aluminum nitrides, gallium nitrides, indium nitrides, etc. Thus, three basic colors of red, blue and green for LEDs have been available for realizing the dream about full-color LEDs.

The conventional light-emitting element employs three LED dies that separately emit lights or two or three of which separately emit lights. This enables an emission of different color lights or white light.

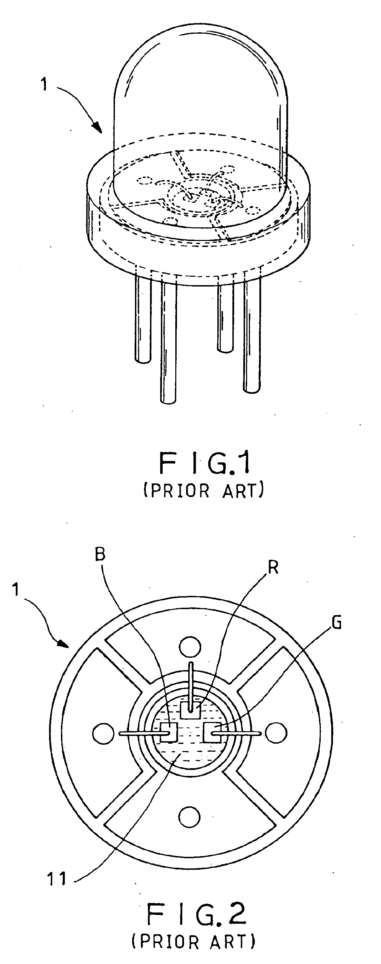

A conventional full-color LED 1 with red-blue-green lights LED is shown in FIGS. 1 and 2. The red, blue, and green diode dies (R), (B), and (G) are separately formed. During a packaging procedure, the three dies are mounted on a p.c. board 11, and this requires a very precise alignment of the red, blue, and green diode dies (R), (B), and (G) for reaching an expected full-color effect. However, it issues a great challenge to packaging manufacturers. The packaging manufacturers have to spend a lot of time on the alignment of the the red, blue, and green diode dies (R), (B), and (G), thereby resulting in a considerable increase in production cost. Moreover, the positioning preciseness is restricted by the existing equipment. Thus, the full-color effect is much affected.

In addition, the red, blue, and green diode dies (R), (B), and (G) are separately distributed on a surface, and this causes an insufficient bonding compactness. Meanwhile, the wave-mixing effect leaves something to be desired. Consequently, the full-color effect will be affected when the full-color LED is seen from a short-distance position.

The LED die is normally developed on a proper substrate, and a semiconductor substrate basically suits for only two LED laser lights having similar spectrum, for example, red and green LEDs or green and blue LEDs. To add the blue LED to the substrate with red and green LEDs issues, however, a large technical challenge to the presently existing semiconductor industry. Many manufactures have taken efforts to develop the red, blue, and green diode dies on a substrate. However, it still takes a long time to reach the stage of its application to industries. By use of existing technique, the development of different color LED dies still needs different substrates. When the development substrates are repetitively etched for emitting lights of different colors, one has to consider if the potential outcome is worthy of carrying out this procedure. When the red, blue, and green diode dies are formed on three different layers, one still has to face problems with respect to its light-emitting efficiency and the heat dissipation.

It is a primary object of the invention to eliminate the aforementioned drawbacks and to provide a full-color LED having a red LED die, a blue LED die, and a green LED die three of which are integrated in a double-layer three-dimensional structure before packaging process. Meanwhile, the red LED die serves as a supporting material on which the blue LED die and the green LED die are separately mounted in such a manner that the red LED die is not completely covered to reserve a red-light emitting surface. In this way, the red, blue, and green LEDs are combined so as to create a full-color LED.

It is another object of the invention to provide a solution to a problem with respect to alignment of the red, blue, and green LED dies for the packaging manufacturers and to provide a full-color LED that can be directly packaged to facilitate necessary procedures after the full-color light-emitting element is electrically connected to the power source.

It is a further object of the invention to provide a full-color LED that allows a more compact mixture of red, green, and blue lights and achieves an exact wave-mixing effect for obtaining a full-color light. Meanwhile, the full-color effect won't be affected when the full-color LED is seen from a short-distance position.

The accomplishment of this and other objects of the invention will become apparent from the following descriptions and its accompanying drawings of which:
FIG. 1 is a perspective view of a conventional full-color light-emitting diode;
FIG. 2 is a top view of FIG. 1;
FIG. 3 is a top view of a first embodiment of the invention;
FIG. 4 is a top view of a second embodiment of the invention;
FIG. 5 is a top view of a third embodiment of the invention;
FIG. 6 is a circuit diagram of the invention when forward biased;
FIG. 7 is a circuit diagram of the invention when reserve biased; and

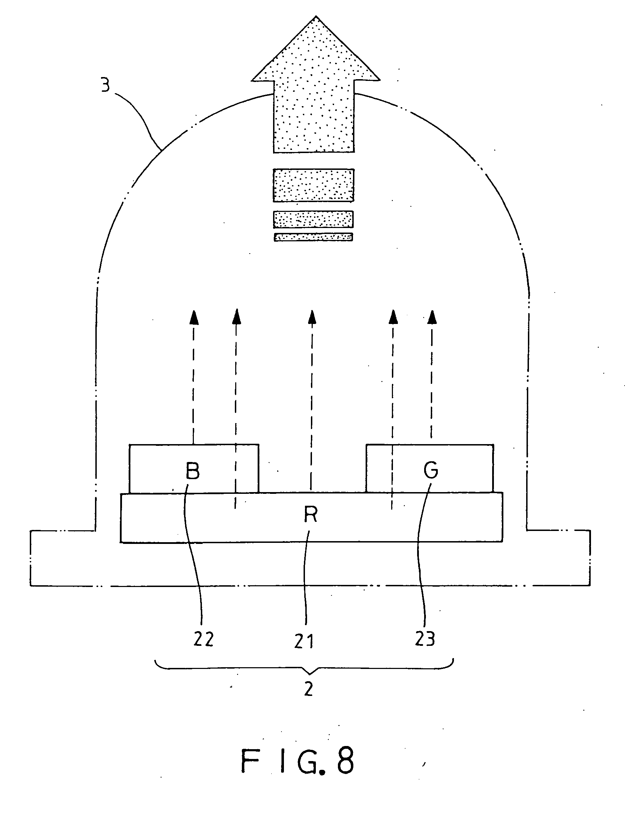

FIG. 8 is a cutaway view of the full-color light-emitting diode of the invention with the illustrated light-emitting direction.

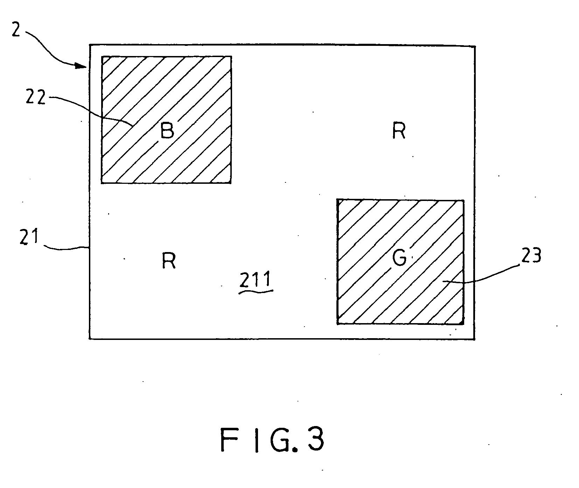

First of all, referring to FIG. 3, a full-color light-emitting diode 2 in accordance with the invention includes a red LED die 21, a blue LED die 22, and a green LED die 23. Each of the light-emitting diode dies 21, 22, 23 is formed by bonding a p-type semiconductor layer and an n-type semiconductor layer. As the red light has a greater wave length than the blue and green lights, the red LED die 21 serves as a supporting material on which the blue LED die 22 and the green LED die 23 are separately mounted in such a manner that the red LED die 21 is not completely covered to reserve a red-light emitting surface 211. In addition that the red light (R) of the supporting material can be sent forth through the uncovered red-light emitting surface 211, the red light (R) can still pass through the blue LED die 22 and the green LED die 23 due to their transparency.

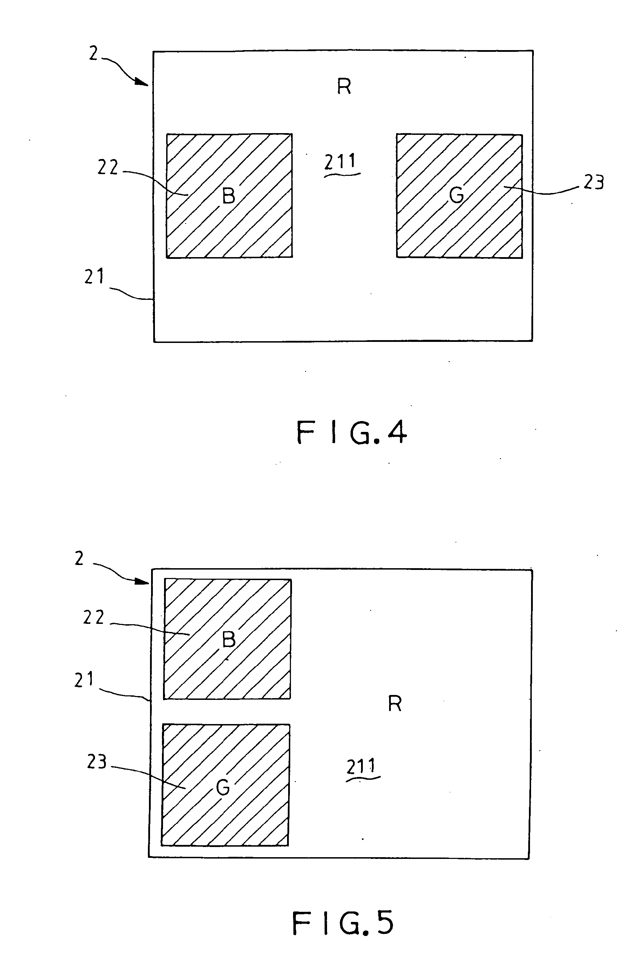

According to a preferred embodiment of the invention illustrated in FIG. 3, the blue LED die 22 and the green LED die 23 are arranged at two nonadjacent vertices on a surface of the red LED die 21. This arrangement provides an optimal evenness in mixing the red, green, and blue light waves. Alternatively, the blue LED die 22 and the green LED die 23 are transversely aligned at the respective sides of the red LED die 21 (see FIG. 4). Also, they can longitudinally aligned at one side of the red LED die 21 (see FIG. 5). Their arrangement way can vary in accordance with different requirements, and details thereof won't be given hereinafter.

The light-emitting diode dies 21, 22, 23 of the invention are fabricated by conventional procedures under consideration of their special dimensions, bias voltage values, brightness, colors, and metallic contact materials.

Besides, the light-emitting diode dies 22, 23 on the second layer of the full-color light-emitting diode 2 are bonded to the red LED die 21 on the first layer by melting, ultrasonic welding techniques , or with transparent glue, etc.

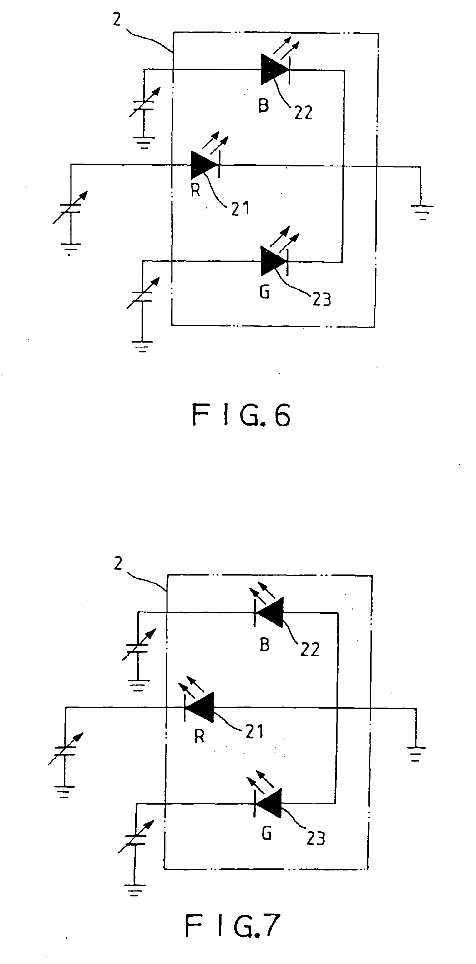

In addition, each LED die 21, 22, 23 has its own anode terminal and cathode terminal. After die bonding procedure, the anode terminals of the LED dies 21, 22, 23 are electrically connected to a voltage source while their cathode terminals are connected to a common ground. In a circuit diagram shown in FIG. 6, a forward bias voltage is applied to the respective LED dies 21, 22, 23. By modulating the forward bias voltage, the electric currents of the respective LED dies 21, 22, 23 are correspondingly changed to produce a desired full-color light by mixing the red, green, and blue lights of different luminous intensity values. To the contrary, as shown in FIG. 7, the terminals of the diode dies 21, 22, 23 are connected in a opposite direction to create a reserve bias. By modulating the reverse bias voltage, the electric currents of the respective LED dies 21, 22, 23 are correspondingly changed to produce a desired full-color light by mixing the red, green, and blue lights of different luminous intensity values.

Before a packaging procedure for a transparent cover 3, the diode dies 21, 22, 23 have been bonded to form a full-color light-emitting diode 2. Thus, alignment of the diode dies 21, 22, 23 is no more necessary for the packaging procedure, thereby ensuring a more precise positioning effect of the diode dies 21, 22, 23. Moreover, this makes the packaging process easier. Furthermore, the overlaying arrangement of the three dies 21, 22, 23 creates a more compact mixture of red, green, and blue lights, thereby achieving an expected full-color effect.

Many changes and modifications in the above-described embodiments of the invention can, of course, be carried out without departing from the scope thereof. Accordingly, to promote the progress in science and the useful arts, the invention is disclosed and is intended to be limited only by the scope of the appended claims.

## Claims

1. A full-color light-emitting diode (LED) comprising a red LED die, a blue LED die, and a green LED die, the red LED die serving as a supporting material on which the blue LED die and the green LED die are separately mounted in such a manner that the red LED die is not completely covered to reserve a red-light emitting surface.

2. The full-color LED as recited in claim 1 wherein each of the red, blue, and green LED dies has its own anode terminal and cathode terminal and wherein by modulating a bias voltage, the electric currents of the respective LED dies are correspondingly changed to produce a desired full-color light by mixing the red, green, and blue lights of different luminous intensity values.

3. The full-color LED as recited in claim 1 wherein the blue LED die and the green LED die are arranged at two nonadjacent vertices on a surface of the red LED die.

4. The full-color LED as recited in claim 1 wherein the blue LED die and the green LED die are arranged in a straight line on the surface of the red LED die.
